# EUROPEAN PATENT APPLICATION

(11) **EP 4 835 176 A1**
(43) Date of publication of application: **04.11.2026**
(21) Application number: 24909874.0
(22) Date of filing: 20.08.2024
(51) Int. Cl.: C30B 29/22, C30B 7/14, H01M 4/525, H01M 4/505, H01M 4/485, H01M 4/36

(54) **METAL OXIDE PRECURSOR AND PREPARATION METHOD THEREFOR AND USE THEREOF**

(30) Priority: 29.12.2023 CN 202311867954
(71) Applicant: HUAYOU NEW ENERGY TECHNOLOGY (QUZHOU) CO., LTD., Quzhou, Zhejiang 324000 (CN); ZHEJIANG HUAYOU COBALT CO., LTD., Jiaxing, Zhejiang 314000 (CN)
(72) Inventor: GUO, Xing, Quzhou, Zhejiang 324000 (CN); ZHAO, Haiying, Quzhou, Zhejiang 324000 (CN); XU, Wei, Quzhou, Zhejiang 324000 (CN); LIU, Zeping, Quzhou, Zhejiang 324000 (CN)
(74) Representative: MERH-IP Matias Erny Reichl Hoffmann Patentanwälte PartG mbB
(86) International application number: PCT/CN2024/113460
(87) International publication number: WO 2025/138924

(57) **Abstract**

A metal oxide precursor, a preparation method therefor, and a use thereof are provided. The metal oxide precursor is a single-crystal structure, and a particle size distribution curve function f(x) of the metal oxide precursor represents a corresponding volume fraction at a particle size x, in which, 0.214 µm ≤ a ≤ 0.260 µm, 1.78 µm ≤ b ≤ 3.1 µm, 8.2 µm ≤ c ≤ 31.2 µm, ε, µ₁, and µ₂ are all error coefficients, and -1.5 ≤ ε ≤ 1.5, -0.35 ≤ µ ≤ 0.35, -3 ≤ µ₂ ≤ 10. The metal oxide precursor of the embodiment of the present application has a high tap density of 1.2 g/cm³ to 3.5 g/cm³, which is beneficial to improve the filling rate and compaction density of the cathode material, thereby improving the volume specific capacity of the battery.

## Description

The present application claims the priority of the Chinese patent application with application number 2023118679548 and titled "Metal oxide precursor, preparation method therefor, and use thereof" filed with the Chinese Patent Office on December 29, 2023, and all the contents thereof are incorporated by reference into the present application.

### TECHNICAL FIELD

The present application relates to the technical field of battery technology, more particularly to a metal oxide precursor, a preparation method therefor, and a use thereof.

### BACKGROUND

The statements here only provide background information related to the present application and do not necessarily constitute prior art. A metal oxide precursor prepared by traditional spray pyrolysis has a relatively uniform particle size and a small size, and the agglomeration phenomenon is relatively serious, resulting in a low tap density of the metal oxide precursors. When used to prepare a cathode material, the metal oxide precursor has a small crucible loading capacity is small, which not only causes problems such as excessive energy consumption, but also makes the volume specific capacity of the cathode material low. In addition, under different preparation conditions, the particle size distribution curves of metal oxide precursors of different elements and proportions are inconsistent and have no obvious rules, which makes it difficult to improve the tap density of the metal oxide precursor.

### SUMMARY

It is one of objectives of embodiments of the present application to provide a metal oxide precursor, a preparation method therefor, and a use thereof, aiming to solve the problem of relatively low tap density of the metal oxide precursor.

Embodiments of the present application adopt the following technical solutions:

In the first aspect, a metal oxide precursor is provided. The metal oxide precursor is a single-crystal structure, and a particle size distribution curve function f(x) of the metal oxide precursor represents a volume fraction corresponding to a particle size x, and satisfies the following conditions:
(1) when a ≤ x ≤ b, f(x) = ε + e^{-0.372+2.157(x+µ₁)-0.514(x+µ₁)²};
(2) when b < x ≤ c, f(x) = ε + e^{-2.382+0.164(x+µ₂)-0.514(x+µ₂)²};
(3) when x < a or x > c, f(x) = 0;
   in which, 0.214 µm ≤ a ≤ 0.260 µm, 1.78 µm ≤ b ≤ 3.1 µm, 8.2 µm ≤ c ≤ 31.2 µm, ε, µ₁, µ₂ are all error coefficients, and -1.5 ≤ ε ≤ 1.5, -0.35 ≤ µ₁ ≤ 0.35, -3 ≤ µ₂ ≤ 10.

In some embodiments, the particle size distribution curve function f(x) of the metal oxide precursor presents a unimodal normal particle size distribution curve.

In some embodiments, a maximum value f(x)ₘₐₓ of the particle size distribution curve function f(x) of the metal oxide precursor is 5 to 10.

In some embodiments, a full width at half maximum (FWHM) of the particle size distribution curve function f(x) of the metal oxide precursor is 3 µm to 5 µm.

In some embodiments, a cumulative particle size distribution curve function corresponding to the particle size distribution curve function f(x) of the metal oxide precursor is defined as Dₙ, n% = ∑ f(x), and when the cumulative particle size distribution curve function is D₂₅, 0.5 µm ≤ x ≤ 2.0 µm.

In some embodiments, a cumulative particle size distribution curve function corresponding to the particle size distribution curve function f(x) of the metal oxide precursor is defined as Dₙ, n% = ∑ f(x), and when the cumulative particle size distribution curve function is D₅₀, 1.2 µm ≤ x ≤ 3.8 µm.

In some embodiments, a cumulative particle size distribution curve function corresponding to the particle size distribution curve function f(x) of the metal oxide precursor is defined as Dₙ, n% = ∑ f(x), and when the cumulative particle size distribution curve function is D₇₅, 2 µm ≤ x ≤ 5 µm.

In some embodiments, in the particle size distribution curve function f(x) of the metal oxide precursor, a particle size distribution span value is 1.0 to 2.5.

In some embodiments, a general chemical formula of the metal oxide precursor is Mn_{y}M_{1-y}O₂, in which, 0.1 ≤ y ≤ 0.9, and M is at least one selected from Ni, Fe, Cu, Zn, Co, Ti, Mg, and Al.

In some embodiments, the metal oxide precursor is a cubic crystal structure.

In some embodiments, a tap density of the metal oxide precursor is 1.2 g/cm³ to 3.5 g/cm³.

In a second aspect, the present application provides a preparation method for the above-mentioned metal oxide precursor. The preparation method adopts spray pyrolysis.

In some embodiments, a pyrolysis temperature of the spray pyrolysis is 550°C to 950°C.

In some embodiments, an atomization pressure of the spray pyrolysis is 0.35 MPa to 0.7 MPa.

In some embodiments, a liquid feed flow rate of the spray pyrolysis is 0.3 m³/hr to 0.8 m³/hr.

A third aspect of the present application provides cathode material made from the above metal oxide precursor or a metal oxide precursor prepared by the above preparation method.

A fourth aspect of the present application provides a cathode plate, comprising: a cathode current collector, and a cathode material layer, which is disposed on a surface of the cathode current collector and comprises the above cathode material.

A fifth aspect of the present application provides a secondary battery, comprising the above cathode plate.

Advantages of the metal oxide precursor provided in embodiments of the present application are summarized as follows: when the particle size distribution curve of the metal oxide precursor of the embodiments of the present application satisfies a specific functional relationship, it presents a unimodal normal particle size distribution curve and exhibits a broad particle size distribution. On the one hand, it is beneficial to improve the tap density of the metal oxide precursor. When the metal oxide precursor is used to prepare a cathode material, it is beneficial to increase the crucible loading capacity and reduce energy consumption. Moreover, the broad distribution particle size characteristics of the metal oxide precursor are easily inherited by the cathode material, so that the cathode material has a higher filling rate and compaction density, which is beneficial to improve the volume specific capacity of the battery. On the other hand, the metal oxide precursor that meets the specific particle size distribution curve function relationship of the embodiments of the present application can be widely applied to different elements and proportions and preparation conditions, and can achieve a higher tap density effect.

Advantages of the preparation method for the cathode plate provided in embodiments of the present application are summarized as follows: the above-mentioned metal oxide precursor in the embodiments of the present application may be prepared by spray pyrolysis. The prepared metal oxide precursor has a single-crystal structure, and the particle size distribution of the single-crystal structure in the precursor satisfies the above-mentioned particle size distribution curve function f(x), which is conducive to improving the tap density of the metal oxide precursor and can be widely applicable to different elements and proportions and preparation conditions.

Advantages of the cathode material provided in embodiments of the present application are summarized as follows: the metal oxide precursor of the present application is used to prepare the cathode material, so that the cathode material inherits the broad distribution particle size characteristics of the metal oxide precursor, achieves a higher filling rate and compaction density, and thus improves the volumetric capacity of batteries such as sodium ion batteries.

Advantages of the cathode plate provided in embodiments of the present application are summarized as follows: the cathode material layer of the cathode plate of the embodiments of the present application includes the above-mentioned cathode material with relatively high filling rate and compaction density, thereby improving the energy density, cycle stability, and other electrochemical properties of the cathode plate.

Advantages of the secondary battery provided in embodiments of the present application are summarized as follows: the cathode plate with high energy density, cycle stability, and other characteristics provided by the above embodiments of the present application is applied to the secondary battery, which can improve the electrochemical properties of the secondary battery such as cycle stability and cycle life.

### BRIEF DESCRIPTION OF THE DRAWINGS

In order to more clearly illustrate the technical solutions in the embodiment of the present application, the drawings required for use in the embodiments or exemplary technical description will be briefly introduced below. Obviously, the drawings described below are only some embodiments of the present application. For ordinary technicians in this field, other drawings can also be obtained based on these drawings without creative work.
FIG. 1 is a particle size distribution curve of a metal oxide precursor in an embodiment of the present application;
FIG. 2 is a scanning electron microscope image of a metal oxide precursor prepared in Example 1;
FIG. 3 is a particle size distribution curve of a metal oxide precursor prepared in Example 1;
FIG. 4 is a scanning electron microscope image of a metal oxide precursor prepared in Example 2;
FIG. 5 is a particle size distribution curve of a metal oxide precursor prepared in Example 2;
FIG. 6 is a particle size distribution curve of a metal oxide precursor prepared in Example 3;
FIG. 7 is a scanning electron microscope image of a metal oxide precursor prepared in Comparative Example 1;
FIG. 8 is a particle size distribution curve of a metal oxide precursor prepared in Comparative Example 1;
FIG. 9 is a particle size distribution curve of a metal oxide precursor prepared in Comparative Example 2; and

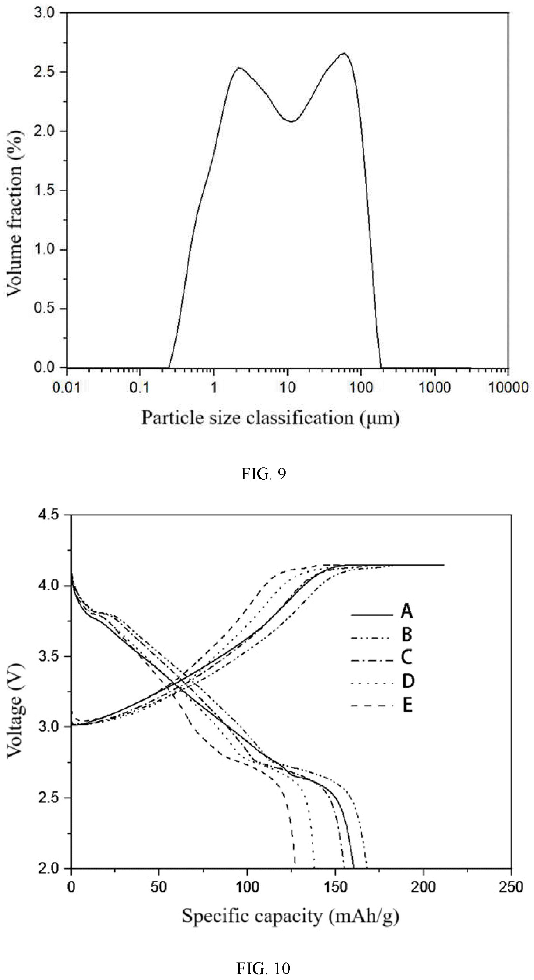

FIG. 10 is a charge and discharge performance test diagram of cathode materials prepared in Examples 1-3 and Comparative Examples 1-2, in which, A is a charge and discharge performance curve of the cathode material prepared in Example 1, B is a charge and discharge performance curve of the cathode material prepared in Example 2, C is a charge and discharge performance curve of the cathode material prepared in Example 3, D is a charge and discharge performance curve of the cathode material prepared in Comparative Example 1, and E is a charge and discharge performance curve of the cathode material prepared in Comparative Example 2.

### DETAILED DESCRIPTION OF THE EMBODIMENTS

In order to clarify the objectives, technical solutions, and advantages of the present application, the present application is further described in detail below in combination with the drawings and embodiments. It should be understood that the specific embodiments described herein are only used to explain the present invention and are not intended to limit the present application.

It should be noted that when a component is referred to as being "fixed to" or "arranged on" another component, it can be directly on the other component or indirectly on the other component. When a component is referred to as being "connected to" another component, it can be directly or indirectly connected to the other component. The orientation or position relationship indicated by the terms "upper", "lower", "left", "right", etc. is based on the orientation or position relationship shown in the drawings, and is only for the convenience of description, and does not indicate or imply that the device or element referred to must have a specific orientation, be constructed and operated in a specific orientation. Therefore, it cannot be understood as a limitation of the present application. For ordinary technicians in this field, the specific meanings of the above terms can be understood according to specific circumstances. The terms "first" and "second" are only used for the purpose of convenience of description, and cannot be understood as indicating or implying relative importance or implicitly indicating the number of technical features. "Multiple" means two or more, unless otherwise clearly and specifically defined.

Unless otherwise defined, all technical and scientific terms used herein have the same meaning as those generally understood by technicians in the technical field of the embodiments of the present application. The terms used in the specification of the embodiments of the present application are only for the purpose of describing specific implementation methods or embodiments, and are not intended to limit the embodiments of the present application. The optional range of the term "and/or" used in this article includes any one of two or more related listed items, and also includes any and all combinations of related listed items, and any and all combinations include any two related listed items, any more related listed items, or all related listed items.

In order to illustrate the technical solution of the present application, the following is a detailed description in conjunction with specific drawings and embodiments.

Some embodiments of the present application provide a metal oxide precursor. The metal oxide precursor is a single-crystal structure, and a particle size distribution curve function f(x) of the metal oxide precursor represents a volume fraction corresponding to a particle size x, and satisfies the following conditions:
(1) when a ≤ x ≤ b, f(x) = ε + e^{-0.372+2.157(x+µ₁)-0.514(x+µ₁)²};
(2) when b < x ≤ c, f(x) = ε + e^{2.382-0.164(x+µ₂)-0.514(x+µ₂)²};
(3) when x < a or x > c, f(x) = 0;
   in which, 0.214 µm ≤ a ≤ 0.260 µm, 1.78 µm ≤ b ≤ 3.1 µm, 8.2 µm ≤ c ≤ 31.2 µm, ε, µ₁, µ₂ are all error coefficients, and -1.5 ≤ ε ≤ 1.5, -0.35 ≤ µ₁ ≤ 0.35, -3 ≤ µ₂ ≤ 10.

It should be noted that the unit of particle size x in the particle size distribution curve function f(x) of the metal oxide precursor in the embodiments of the present application is µm by default. When calculating f(x), only the value of x needs to be substituted, and there is no need to substitute the unit of µm. The unit of the corresponding volume fraction f(x) calculated at any particle size x is %. In addition, a particle size of the metal oxide precursor refers to a macroscopic morphology. When performing a conventional particle size distribution detection, the particle size distribution in the dispersion pool includes the agglomerated state; the precursor of the single-crystal has structural inheritance and is easy to sinter into a single-crystal cathode. The single-crystal structure has fewer grain boundaries, which is beneficial to improve the electronic and ionic conductivity, and thus improve the battery rate performance. In addition, due to the fewer grain boundaries, the defects caused is fewer, and the strength and stability are higher, and the occurrence of side reactions at the grain boundaries is also reduced, thereby improving the cycle life of the battery. The chemical composition and structure inside the single-crystal structure are more uniform, which helps to uniformly carry out the electrochemical reaction.

The particle size distribution in the metal oxide precursor of the embodiments of the present application satisfies the above-mentioned particle size distribution curve function f(x), and the correlation between f(x) and the tap density of the precursor is as follows: the particle size corresponding to the peak position represents a most common particle size, and the broader particle size distribution indicates that the particle size is diverse, which is more conducive to filling gaps under vibration conditions and improving the tap density. When a ≤ x ≤ b, f(x) represents a particle size distribution smaller than a median diameter; when b < x ≤ c, f(x) represents a particle size distribution larger than a median diameter; when x < a or x > c represents a particle size outside the f(x) distribution. This function can reflect the particle size distribution characteristics of the product of the present application. three characteristic maximum values of x are defined as follows: X = a and X = c respectively represent minimum and maximum particle size values in the sample, and X = b is the highest point of the particle size distribution curve, indicating that particles of this particle size occupy the largest proportion in the sample. For symmetrical distribution: the peak value is the value corresponding to D₅₀. In asymmetrical distribution, the D₅₀ value may be slightly different. When x = b, when parameter b takes a larger value, the median diameter particles are larger, the stacking pores are more, and the tap density may be lower; and when the peak particle size is smaller, the particles are finer, the stacking is more compact, and the tap density may be higher. When X = a and X = c, the greater the difference between the maximum particle size and the minimum particle size, the higher the diversity of the particles. Larger particles help support the stacking structure and prevent over-compaction, while smaller particles help fill the voids, thereby increasing the tap density. Parameter a represents a minimum particle size. If the small particle size value is too small, the adhesion between particles may increase, affecting the fluidity and processing performance; and an appropriately small minimum particle size helps fill the voids and increase the tap density. Parameter b represents a maximum particle size. A larger maximum particle size may increase the stacking voids, reduce the tap density, and affect the uniformity of the reaction, but appropriately large particles can help support the stacking structure and prevent over-compaction. Parameter c represents a peak particle size. If the median diameter value is too large, the tap density will decrease, affecting the energy density of the battery and reducing the conductivity; and if the median diameter value is too small, agglomeration may be easily resulted during processing, affecting the uniformity of the slurry and the coating process. A moderate median diameter value can balance the tap density, conductivity and cycle stability, therefore, this range is preferred.

In some embodiments, the particle size distribution curve function f(x) of the metal oxide precursor presents a unimodal normal particle size distribution curve. When the particle size distribution curve of the metal oxide precursor of the embodiments of the present application satisfies a specific functional relationship, it presents a unimodal normal particle size distribution curve and exhibits a broad particle size distribution. On the one hand, it is beneficial to improve the tap density of the metal oxide precursor. When the metal oxide precursor is used to prepare a cathode material, it is beneficial to increase the crucible loading capacity and reduce energy consumption. Moreover, the broad distribution particle size characteristics of the metal oxide precursor are easily inherited by the cathode material, so that the cathode material has a higher filling rate and compaction density, which is beneficial to improve the volume specific capacity of the battery. On the other hand, the metal oxide precursor that meets the specific particle size distribution curve function relationship of the embodiments of the present application can be widely applied to different elements and proportions and preparation conditions, and can achieve a higher tap density effect.

In some embodiments, a tap density of the metal oxide precursor is 1.2 g/cm³ to 3.5 g/cm³. In such condition, the metal oxide precursor has a high tap density of 1.2 g/cm³ to 3.5 g/cm³, which is beneficial to increase the crucible loading capacity and reduce energy consumption when used to prepare the cathode material. Moreover, the broad distribution particle size characteristics of the metal oxide precursor are easily inherited by the cathode material, so that the cathode material has a higher filling rate and compaction density, which is beneficial to improve the volume specific capacity of the battery. Exemplarily, the high tap density of the metal oxide precursor may be 1.2 g/cm³, 1.5 g/cm³, 1.8 g/cm³, 2.0 g/cm³, 2.5 g/cm³, 3 g/cm³, 3.5 g/cm³, and other typical but non-limiting arbitrary point values or interval values between any two point values.

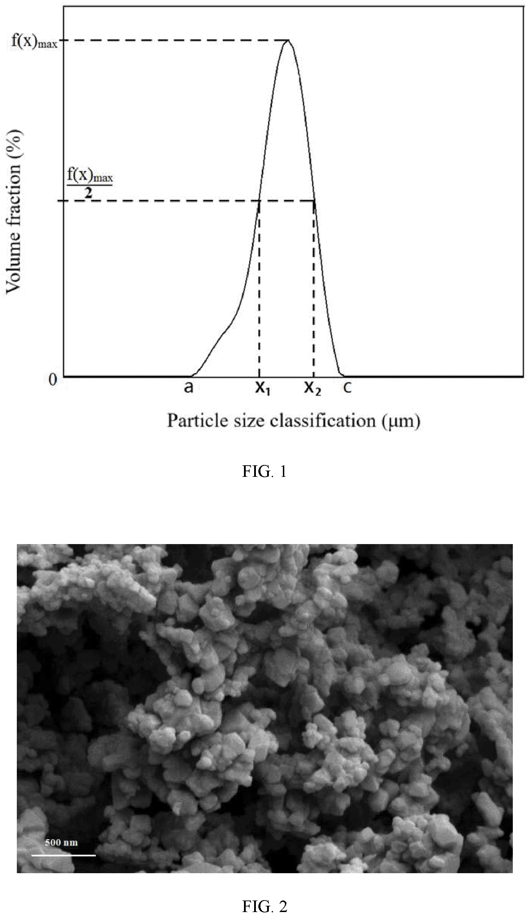

FIG. 1 is a particle size distribution curve of a metal oxide precursor in an embodiment of the present application. A highest point of the particle size distribution curve function f(x) of the metal oxide precursor is a maximum value f(x)ₘₐₓ, and f(x)ₘₐₓ ranges from 5 to 10. Exemplarily, the maximum value f(x)ₘₐₓ of the particle size distribution curve function f(x) of the metal oxide precursor may be any typical but non-limiting point value such as 5, 6, 7, 8, 9, 10, or an interval value between any two point values. If the maximum value is too large, a large number of voids will be caused in the stacking process, affecting the tap density, thereby reducing the energy density; if the maximum value is too small, the agglomeration phenomenon between the particles will be aggravated, which is not conducive to uniform slurring and coating. f(x)ₘₐₓ within the range of 5 to 10 helps to optimize the tap density and the filling effect between particles, thereby improving the energy density and structural stability.

In some embodiments, a full width at half maximum of the particle size distribution curve function f(x) of the metal oxide precursor is defined as the difference between a particle size x₁ and a particle size x₂ corresponding to the particle size distribution curve function f(x) at the half-maximum value f(x)ₘₐₓ/2, in which, the particle size x₁ and the particle size x₂ are independently selected from any value between 0.6 µm and 6 µm.

In some embodiments, the full width at half maximum of the particle size distribution curve function f(x) of the metal oxide precursor is 3 µm to 5 µm. Exemplarily, the full width at half maximum of the particle size distribution curve function f(x) of the metal oxide precursor may be any typical but non-limiting point value, such as 3 µm, 4 µm, 5 µm, or an interval value between any two point values. The full width at half maximum indicates the consistency of the particle size. A small full width at half maximum indicates uniform particle size, and a large full width at half maximum indicates diversity of particle size. Within the full width at half maximum of 3 µm to 5 µm, the particle size has a certain diversity, and small particles fill the gaps to achieve a higher tap density, thereby improving the battery capacity and energy density.

In some embodiments, the cumulative particle size distribution curve function corresponding to the particle size distribution curve function f(x) of the metal oxide precursor is Dₙ, in which, f(x) is defined as a volume percentage of the particle size when the particle size is x µm; Dₙ is defined as a particle size corresponding to the maximum x in the cumulative process when the cumulative volume fraction is n%; and n% is defined as a total volume fraction when the volume percentage is accumulated from f(xₘᵢₙ) to f(x). When the cumulative particle size distribution curve function is D₂₅, 0.5 µm <x ≤ 2.0 µm. It should be noted that particle size distribution refers to the volume percentage of particles of different particle sizes in the powder sample measured by specific instruments and methods, and n in Dₙ is the percentage. D₂₅ is the particle size corresponding to a cumulative particle size distribution of 25% for the metal oxide precursor. In a case where D₂₅ is too large, it is indicated that the proportion of smaller particles is low, which may lead to a reduction in the reaction surface area and a possible reduction in the initial discharge capacity of the battery. If D₂₅ is too small, it is indicated that the proportion of smaller particles is high, which can increase the reaction surface area and improve the initial capacity, but it will increase side reactions and affect the cycle life. If D₂₅ is within the range of 0.5 µm ≤ x ≤ 2.0 µm, it can increase the initial capacity while reducing side reactions and improving the cycle life.

In some embodiments, a cumulative particle size distribution curve function corresponding to the particle size distribution curve function f(x) of the metal oxide precursor is defined as Dₙ, n% = Σ f(x), and when the cumulative particle size distribution curve function is D₅₀, 1.2 µm ≤ x ≤ 3.8 µm. It should be noted that D₅₀ is the particle size corresponding to a cumulative particle size distribution of 50% for the metal oxide precursor. D₅₀ (median particle size): if D₅₀ is too large, it may lead to insufficient specific surface area, poor conductivity, low electrode density and structural stability problems, reducing the overall performance and life of the battery. If D₅₀ is too small, although it may increase the reaction activity and specific surface area, but it will also bring about problems such as increased side reactions, particle agglomeration and decreased mechanical strength. When D₅₀ is within the range of 1.2 µm ≤ x ≤ 3.8 µm, it can ensure the specific surface area and reaction activity while avoiding excessive side reactions, and meanwhile, improve the tap density and conductivity, and improve the energy density and rate performance of the battery.

In some embodiments, a cumulative particle size distribution curve function corresponding to the particle size distribution curve function f(x) of the metal oxide precursor is defined as Dₙ, n% = Σ f(x), and when the cumulative particle size distribution curve function is D₇₅, 2 µm ≤ x ≤ 5 µm. It should be noted that D₇₅ is the particle size corresponding to a cumulative particle size distribution of 75% for the metal oxide precursor. D₇₅ (content of larger particles): If D₇₅ is too large, the proportion of larger particles is higher, and the voids are large during stacking, resulting in low tap density, which affects the energy density. If D₇₅ is too small, the proportion of larger particles is lower, which increases the tap density and energy density, but smaller particles are more prone to deformation and stress concentration during volume changes, resulting in structural deformation or damage to the material, thereby affecting the structural stability. When D₇₅ is in the range of 2 µm ≤ x ≤ 5 µm, it is possible to maintain structural stability while increasing energy density.

In some embodiments, in the particle size distribution curve function f(x) of the metal oxide precursor, a particle size distribution span value is 1.0 to 2.5. Exemplarily, in the particle size distribution curve function f(x) of the metal oxide precursor, the particle size distribution span value may be 1.0, 1.5, 2.0, 2.5, and other typical but non-limiting arbitrary point values or interval values between any two point values. It should be noted that the particle size distribution span value is K90 = (D₉₀-D₁₀)/D₅₀, in which, D₁₀ is the particle size corresponding to a cumulative particle size distribution of 10% for the metal oxide precursor when it reaches 10%, and D₉₀ is the particle size corresponding to a cumulative particle size distribution of 90% for the metal oxide precursor. D₁₀ is too large, indicating that very small particles account for a low proportion, which will reduce the surface area and thus affect the initial discharge capacity. In a case that D₁₀ is too small, it is indicated that very small particles account for a high proportion, which will cause agglomeration and increase side reactions, and reduce the cycle life. A D₉₀ value that is too large will lead to problems such as uneven particle distribution, insufficient specific surface area, low compaction density, poor mechanical properties, and large volume changes, affecting the electrochemical performance and cycle stability of the battery. In a case where the D₉₀ value is too small, although it can increase the specific surface area and initial capacity, it will also increase side reactions, leading to problems such as capacity attenuation and decreased cycle stability.

In some embodiments, a general chemical formula of the metal oxide precursor is Mn_{y}M_{1-y}O₂, in which, 0.1 ≤ y ≤ 0.9, and M is at least one selected from Ni, Fe, Cu, Zn, Co, Ti, Mg, and Al. It is understood that the metal oxide precursor in the embodiments of the present application may be a binary metal oxide, a ternary metal oxide, or a quaternary metal oxide, which is not limited in the embodiments of the present application.

In some embodiments, the metal oxide precursor exhibits a cubic crystal structure, that is, the single-crystal structure of the metal oxide precursor is a cubic crystal structure.

The embodiments of the present application provide a preparation method for the above-mentioned metal oxide precursor. The preparation method adopts spray pyrolysis.

The above-mentioned metal oxide precursor in the embodiments of the present application may be prepared by spray pyrolysis. The prepared metal oxide precursor has a single-crystal structure, and the particle size distribution of the single-crystal structure in the precursor satisfies the above-mentioned particle size distribution curve function f(x), which is conducive to improving the tap density of the metal oxide precursor and can be widely applicable to different elements and proportions and preparation conditions.

It should be noted that the specific operation of the spray pyrolysis can refer to the existing method, which will not be repeated herein in the embodiments of the present application.

In some embodiments, a pyrolysis temperature of the spray pyrolysis is 550°C to 950°C. Under the pyrolysis temperature condition, when the pyrolysis temperature is low, the generated particles may be large and unevenly distributed, and the crystallinity is low. When the pyrolysis temperature is high, the droplet decomposition rate is accelerated, the particle size is reduced, and the particle size distribution tends to be uniform. When the pyrolysis temperature is too high, sintering and agglomeration of the particles may be resulted, leading to an increase in particle size and a broader particle size distribution.

It should be noted that the pyrolysis temperature is the working temperature of the pyrolysis device.

In some embodiments, an atomization pressure of the spray pyrolysis is 0.35 MPa to 0.7 MPa. Under the pyrolysis temperature condition, if the atomization pressure is high, the atomized droplets are small, and are easier to form uniform small particles during the pyrolysis process. However, if the atomization pressure is too high, some droplets may quickly aggregate during the spraying process, forming a secondary agglomeration phenomenon. If the atomization pressure is low, the atomized droplets are larger, the generated particles are large in size and the particle size distribution is broad. Within the range of the atomization pressure of the present application, the particle size is moderate with a relatively broad unimodal distribution, which is conducive to improving the tap density while exhibiting minimal agglomeration.

In some embodiments, a liquid feed flow rate obtained by the spray pyrolysis is 0.3 m³/hr to 0.8 m³/hr. Under the condition of this pyrolysis temperature range, if the liquid feed flow rate is too large, due to the limited atomization capacity of the nozzle, a large amount of liquid cannot be fully dispersed into small droplets, resulting in some droplets failing to completely dry, forming larger particles or agglomeration, which may cause the particle size distribution to be too broad. If the liquid feed flow rate relatively low, the droplets have enough time to dry and decompose to form smaller and uniform particles. Within the range of the liquid feed flow rate of the present application, the particle size is moderate with a relatively broad unimodal distribution, which is conducive to improving the tap density while exhibiting minimal agglomeration.

Exemplarily, the pyrolysis temperature of the spray pyrolysis may be 550°C, 600°C, 650°C, 700°C, 800°C, 900°C, 950°C, and other typical but non-limiting arbitrary point values or interval values between any two point values. The atomization pressure may be 0.35 MPa, 0.4 MPa, 0.5 MPa, 0.6 MPa, 0.7 MPa, and other typical but non-limiting arbitrary point values or interval values between any two point values. The feed flow rate may be 0.3 m³/hr, 0.4 m³/hr, 0.5 m³/hr, 0.6 m³/hr, 0.7 m³/hr, 0.8 m³/hr, and other typical but non-limiting arbitrary point values or interval values between any two point values.

By adjusting the conditions, such as the pyrolysis temperature, atomization pressure, and liquid feed flow rate, it is beneficial to accurately control the metal oxide precursors prepared using different elements and proportions so that they can all meet the specific particle size distribution curve function of the embodiments of the present application, thereby achieving a higher tap density effect.

The preparation method meets the above-mentioned conditions, such as the pyrolysis temperature, atomization pressure, and liquid feed flow rate. It is understandable that other preparation methods that do not meet the above-mentioned conditions, such as the pyrolysis temperature, atomization pressure, and liquid feed flow rate can also make the metal oxide precursor have a specific particle size distribution curve under certain conditions, which are not limited herein in embodiments of the present application.

The present application also provides a cathode material made from the above metal oxide precursor.

The metal oxide precursor of the present application is used to prepare the cathode material, so that the cathode material inherits the broad distribution particle size characteristics of the metal oxide precursor, achieves a higher filling rate and compaction density, and thus improves the volumetric capacity of batteries such as sodium ion batteries.

It should be noted that the preparation method of the cathode material refers to the existing method, which will not be repeated herein in the embodiments of the present application.

Embodiments of the present application further provide a cathode plate, including a cathode current collector and a cathode material layer disposed on a surface of the cathode current collector. The cathode material layer includes the above-mentioned cathode material.

The cathode material layer of the cathode plate of the embodiments of the present application includes the above-mentioned cathode material with the improved discharge capacity and cycle performance, thereby improving the energy density, cycle stability, and other electrochemical properties of the cathode plate.

Embodiments of the present application further provide a secondary battery, including the above-mentioned cathode plate.

In the embodiments of the present application, the cathode plate having high energy density and high compaction density is applied to a secondary battery, which can improve the electrochemical properties of the secondary battery, such as cycle stability and cycle life.

For example, the secondary battery can be a sodium ion battery.

In an embodiment, the cathode current collector can be a metal foil or a composite current collector, for example, aluminum foil is used as the metal foil; the composite current collector can be formed by forming a metal material on a polymer material substrate. The metal material includes but is not limited to at least one of aluminum, aluminum alloy, nickel, nickel alloy, titanium, titanium alloy, silver and silver alloy, and the polymer material substrate includes but is not limited to at least one of polypropylene (PP), polyethylene terephthalate (PET), polybutylene terephthalate (PBT), polystyrene (PS) and polyethylene (PE).

It can be understood that the cathode material layer also includes a binder and a conductive agent. The binder may be any commercially available binder for cathode plates, including but not limited to at least one of polyvinylidene fluoride (PVDF), polytetrafluoroethylene (PTFE), vinylidene fluoride-tetrafluoroethylene-propylene terpolymer, vinylidene fluoride-fluoropropylene-tetrafluoroethylene terpolymer, tetrafluoroethylene-hexafluoropropylene copolymer, and fluorine-containing acrylate resin, or a binder prepared by any known method, which is not limited to in the embodiments of the present application; The conductive agent may be any commercially available conductive agent for sodium ion batteries, such as carbon black, graphite, etc.

Hereinbelow, a metal oxide precursor, a preparation method thereof, and an application thereof will be further described through the following specific examples. However, those skilled in the art will understand that the following examples are only used to illustrate the embodiments of the present application and should not be regarded as limiting the scope of the embodiments of the present application. If the specific conditions are not specified in the examples, they shall be carried out according to conventional conditions or conditions recommended by the manufacturer. The reagents or instruments used without indicating the manufacturer are all conventional products that can be purchased commercially.

### Example 1

A nickel salt, an iron salt, and a manganese salt were prepared into a mixed metal salt solution in a metal atomic molar ratio of 1:1:1, and then the mixed metal salt solution was introduced into the roasting furnace in the form of droplets at a liquid feed flow rate of 0.38 m³/hr and an atomization pressure of 0.35 MPa. Under a pyrolysis temperature of 550°C, the droplets underwent evaporation, drying, thermal decomposition, sintering, and other processes to form the metal oxide precursor. The obtained metal oxide precursor product was simply denoted as NFM111.

A surface morphology of the metal oxide precursor prepared in this example is shown in FIG. 2. It can be seen that the metal oxide precursor is a single-crystal structure, and a particle size distribution is broad, and the agglomeration phenomenon is significantly improved.

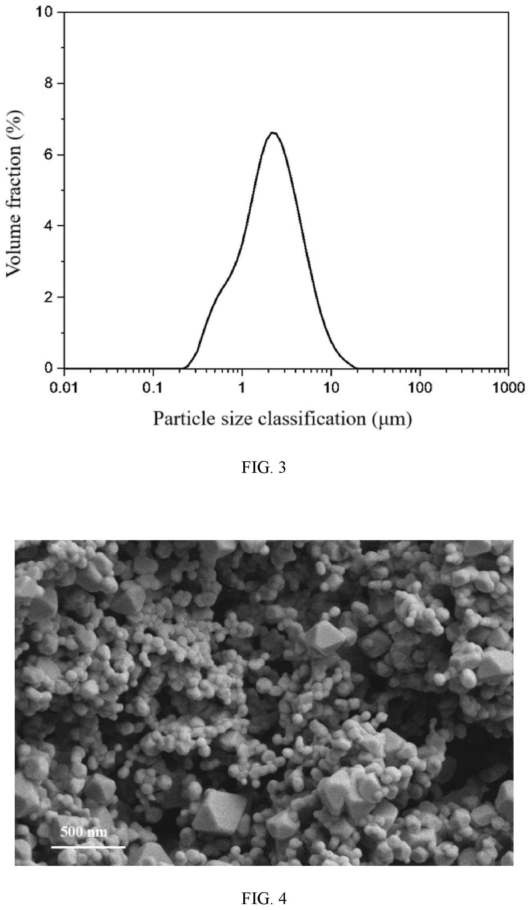

The particle size distribution curve of the metal oxide precursor prepared in this example is shown in FIG. 3. It can be seen that the particle size distribution curve of the metal oxide precursor is a normal curve with a unimodal broad distribution, and the particle size distribution curve function f(x) satisfies: when 0.243 ≤ x ≤ 2.421, f(x) = -1.43 + *e*^{-0.3 72+2.157(x+0.23)-0.514(x+0.2 3)²}; when 2.421 ≤ x ≤ 18.664, f(x) = -1.43 + *e*^{2.382-0.164(x+8.6)-0.514(x+8.6)²}; and when x < 18.664 or x > 0.243, f(x) = 0.

### Example 2

A nickel salt, a copper salt, an iron salt, and a manganese salt were prepared into a mixed metal salt solution in a metal atomic molar ratio of 2:1:3:3, and then the mixed metal salt solution was introduced into a roasting furnace in the form of droplets at a liquid feed flow rate of 0.55 m³/hr and an atomization pressure of 0.7 MPa. Under a pyrolysis temperature of 950°C, the droplets underwent evaporation, drying, thermal decomposition, sintering, and other processes to form the metal oxide precursor. The obtained metal oxide precursor product was simply denoted as NCFM2133.

A surface morphology of the metal oxide precursor prepared in this example is shown in FIG. 4. It can be seen that the metal oxide precursor is a single-crystal structure, and the particle size distribution is broad, and the agglomeration phenomenon is significantly improved.

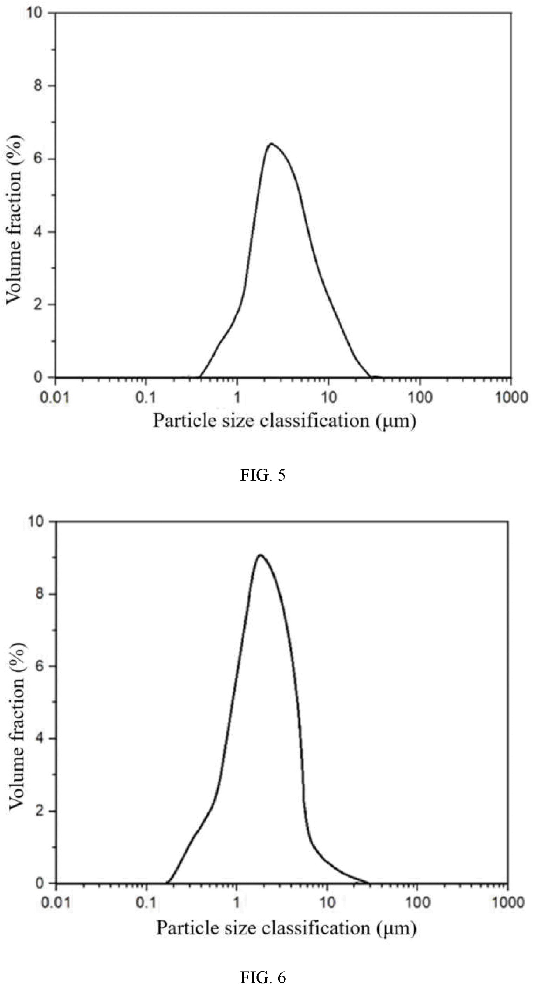

The particle size distribution curve of the metal oxide precursor prepared in this example is shown in FIG. 5. It can be seen that the particle size distribution curve of the metal oxide precursor is a normal curve with a unimodal broad distribution, and the particle size distribution curve function f(x) satisfies: when 0.214 ≤ x ≤ 1.73, f(x) = -1.5 + *e*^{-0.372+2.157(x-0.34)-0.514(x-0.34)²}; when 1.73 ≤ x ≤ 8.3, f(x) = -1.5 + *e*^{2.382-0.164(x+9.8)-0.514(x+9.8)²}; and when x < 8.3 or x > 0.214, f(x) = 0.

### Example 3

An iron salt and the manganese salt were prepared into a mixed metal salt solution in a metal atomic molar ratio of 65:35, and then the mixed metal salt solution was introduced into a roasting furnace in the form of droplets at a liquid feed flow rate of 0.80 m³/hr and an atomization pressure of 0.5 MPa. Under a pyrolysis temperature of 720°C, the droplets underwent evaporation, drying, thermal decomposition, sintering, and other processes to form the metal oxide precursor. The obtained metal oxide precursor product was simply denoted as FM6535.

The particle size distribution curve of the metal oxide precursor prepared in this example is shown in FIG. 6. It can be seen that the particle size distribution curve of the metal oxide precursor is a normal curve with a unimodal broad distribution, and the particle size distribution curve function f(x) satisfies: when 0.255 ≤ x ≤ 3.08, f(x) = 1.48 + e^{-0.372+2.157(x+0.347)-0.514(x+0.347)²}; when 3.08 ≤ x ≤ 31.1, f(x) = 1.48 + e^{2.382-0.164(x-2.97)-0.514(x-2.97)²}; and when x ≤ 31.1 or x > 0.255, f(x) = 0.

### Example 4

A nickel salt, a cobalt salt, and a manganese salt were prepared into a mixed metal salt solution in a metal atomic molar ratio of 80:10:10, and then the mixed metal salt solution was introduced into a roasting furnace in the form of droplets at a liquid feed flow rate of 0.35 m³/hr and an atomization pressure of 0.8 MPa. Under a pyrolysis temperature of 650°C, the droplets underwent evaporation, drying, thermal decomposition, sintering, and other processes to form the metal oxide precursor. The obtained metal oxide precursor product was simply denoted as NCM811.

The particle size distribution of the metal oxide precursor prepared in this example is a normal curve with a unimodal broad distribution, and the particle size distribution curve function f(x) satisfies: when 0.257 ≤ x ≤ 1.89, unimodal broad distribution; when 1.89 < x ≤ 9.36, f(x) = 1.25 + e^{2.382-0.164(x+8.79)-0.514(x+8.79)²}; and when x < 8.97 or x > 0.257, f(x) = 0.

### Example 5

A nickel salt, a cobalt salt, a manganese salt, and a titanium salt were prepared into a mixed metal salt solution in a metal atomic molar ratio of 60:10:20:10, and then the mixed metal salt solution was introduced into a roasting furnace in the form of droplets at a liquid feed flow rate of 0.5 m³/hr and an atomization pressure of 0.6 MPa. Under a pyrolysis temperature of 800°C, the droplets underwent evaporation, drying, thermal decomposition, sintering, and other processes to form the metal oxide precursor. The obtained metal oxide precursor product was simply denoted as NCMT6121.

The particle size distribution of the metal oxide precursor prepared in this example is a normal curve with a unimodal broad distribution, and the particle size distribution curve function f(x) satisfies: when 0.216 ≤ x ≤ 3.03, f(x) = 1.47 + e^{-0.372+2.157(x+0.29)-0.514(x+0.29)²}; when 3.03 < x ≤ 28.95, f(x) = 1.47 + e^{2.382-0.164(x-2.84)-0.514(x-2.84)²}; and when x < 28.95 or x > 0.216, f(x) = 0.

### Comparative Example 1

A nickel salt, an iron salt, and a manganese salt were prepared into a mixed metal salt solution in a metal atomic molar ratio of 1:1:1, and then the mixed metal salt solution was introduced into a roasting furnace in the form of droplets at a liquid feed flow rate of 0.25 m³/hr and an atomization pressure of 0.35 MPa. Under a pyrolysis temperature of 500°C, the droplets underwent evaporation, drying, thermal decomposition, sintering, and other processes to form the metal oxide precursor. The obtained metal oxide precursor product was simply denoted as NFM111.

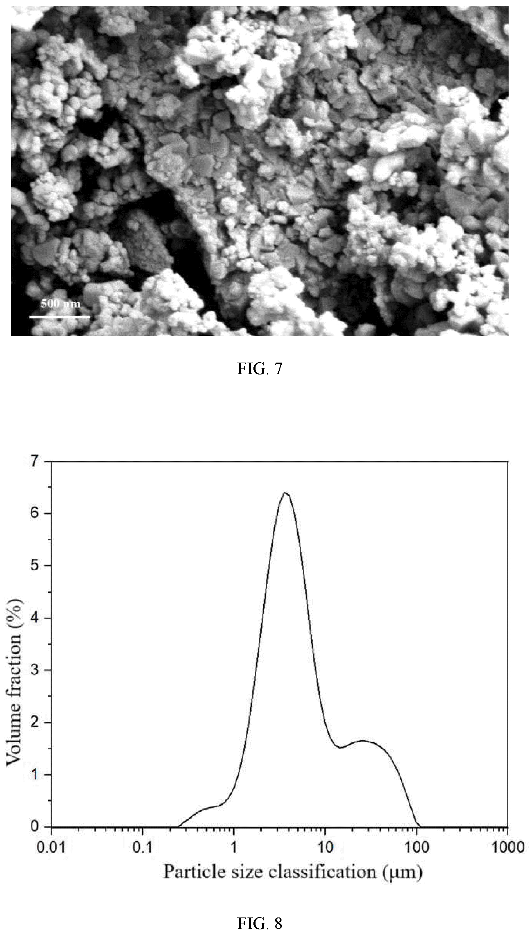

A surface morphology of the metal oxide precursor prepared in this comparative example is shown in FIG. 7, and it can be seen that the agglomeration phenomenon of the metal oxide precursor is extremely serious.

The particle size distribution curve of the metal oxide precursor prepared in this comparative example is shown in FIG. 8, and it can be seen that the metal oxide precursor exhibits a broad particle size distribution with a bimodal pattern, and does not meet the particle size distribution curve function f(x) provided in embodiments of the present application.

### Comparative Example 2

A nickel salt, a copper salt, an iron salt, and a manganese salt were prepared into a mixed metal salt solution in a metal atomic molar ratio of 2:1:3:3, and then the mixed metal salt solution was introduced into a roasting furnace in the form of droplets at a liquid feed flow rate of 0.85 m³/hr and an atomization pressure of 0.7 MPa. Under a pyrolysis temperature of 1000°C, the droplets underwent evaporation, drying, thermal decomposition, sintering, and other processes to form the metal oxide precursor. The obtained metal oxide precursor product was simply denoted as NCFM2133.

The particle size distribution curve of the metal oxide precursor prepared in this comparative example is shown in FIG. 9, and it can be seen that the metal oxide precursor exhibits a broad particle size distribution with a bimodal pattern, and does not meet the particle size distribution curve function f(x) provided in embodiments of the present application.

### Comparative Example 3

A nickel salt, a cobalt salt, and a manganese salt were prepared into a mixed metal salt solution in a metal atomic molar ratio of 8:1:1, and then the mixed metal salt solution was introduced into a roasting furnace in the form of droplets at a liquid feed flow rate of 0.3 m³/hr and an atomization pressure of 0.2 MPa. Under a pyrolysis temperature of 1000°C, the droplets underwent evaporation, drying, thermal decomposition, sintering, and other processes to form the metal oxide precursor. The obtained metal oxide precursor product was simply denoted as NCFM811.

The metal oxide precursor prepared in this comparative example has a large particle size and its irregular agglomeration phenomenon is extremely serious.

The particle size distribution curve of the metal oxide precursor prepared in this comparative example presents an extremely narrow unimodal distribution, and its particle size distribution curve function f(x) satisfies but is not within the preferred range of the present application: when 0.315 ≤ x ≤ 1.54, f(x) = 1.65 + e^{-0.372+2.157(x-0.4)-0.514(x-0.4)²}; when 1.54 < x ≤ 6.82, f(x) = 1.65 + e^{-0.372+2.157(x+11.5)-0.514(x+11.5)²}; and when x < 6.82 or x > 0.315, f(x) = 0.

According to the particle size distribution curves of the metal oxide precursors prepared in Examples 1-5 and Comparative Examples 1 and 3, the particle size distribution parameters measured are shown in Table 1 below.

**Table 1**

| | Examp le 1 | Examp le 2 | Examp le 3 | Exampl e 4 | Exampl e 5 | Comparativ e Example 1 | Comparati ve Example 2 | Comparati ve Example 3 |
|---|---|---|---|---|---|---|---|---|
| Product Model | NFM1 11 | NCFM 2133 | FM653 5 | NCM8 11 | NCMT6 121 | NFM111 | NCFM213 3 | NCM811 |
| D₂₅ (µm) | 1.02 | 0.91 | 1.76 | 0.70 | 0.69 | 2.45 | 2.3 | 2.89 |
| D₅₀ (µm) | 2.81 | 2.35 | 3.45 | 1.43 | 2.93 | 4.72 | 9.25 | 4.10 |
| D₇₅ (µm) | 3.93 | 3.10 | 4.91 | 3.19 | 4.96 | 9.86 | 35.9 | 5.51 |
| K₉₀ | 1.49 | 1.78 | 1.92 | 1.25 | 4.94 | 16.2 | 8.51 | 0.79 |
| Half peak width (µm) | 3.95 | 4.59 | 4.83 | 3.12 | 4.97 | 5.74 | 122.75 | 1.82 |
| Maximum value f(x)ₘₐₓ (%) | 6.71 | 6.53 | 9.71 | 5.32 | 9.85 | 6.41 | 2.66 | 4.91 |
| Particle size correspon ding to maximum value (µm) | 2.43 | 1.73 | 3.08 | 5.73 | 9.85 | 3.55 | 58.9 | 12.36 |
| Tap density TD (g/cm³) | 2.1 | 1.5 | 2.7 | 1.24 | 3.46 | 1.0 | 1.1 | 0.86 |

From the above test results, it can be seen that when the particle size distribution of the single-crystal particles in the metal oxide precursor of the embodiments of the present application satisfies the particle size distribution curve function f(x) of the present application, the tap density of the prepared metal oxide precursor is 1.2 g/cm³ to 3.5 g/cm³. Having a high tap density is conducive to improving the filling rate and compaction density of the cathode material, thereby improving the volume specific capacity of the battery.

### Application Example

The metal oxide precursors obtained in Examples 1-5 and Comparative Examples 1-3 each were respectively mixed with sodium carbonate at a molar ratio of 1:1. A resulting mixture was then placed in a muffle furnace, heated to 900°C at a heating rate of 5°C/min under an air atmosphere, and sintered at a constant temperature for 15 hrs. After natural cooling, the product was crushed and sieved to obtain the cathode material.

The prepared cathode materials were made into a sodium ion button battery, and the charge and discharge performances were tested under a voltage condition of 2 V to 4.15 V, respectively. The test results are shown in FIG. 10 and Table 2 below.

**Table 2**

| | First discharge specific capacity (mAh/g) |
|---|---|
| Example 1 | 160.5 |
| Example 2 | 167.8 |
| Example 3 | 154.9 |
| Example 4 | 171.2 |
| Example 5 | 189.8 |
| Comparative Example 1 | 138.2 |
| Comparative Example 2 | 127.5 |
| Comparative Example 3 | 155.7 |

According to FIG. 10 and Table 2, the cathode materials prepared in Examples 1-5 have a high first discharge specific capacity under the voltage condition of 2 V to 4.15 V, with the highest reaching about 167.8 mAh/g. Compared with Example 1, the first discharge specific capacity of Comparative Example 1 is significantly lower; and compared with Example 2, the first discharge specific capacity of Comparative Example 2 is significantly worse. Therefore, the metal oxide precursor of the examples of the present application can meet the specific unimodal normal particle size distribution curve, not only has a high tap density of 1.2 g/cm³ to 3.5 g/cm³, but also can be widely applied to different elements and proportions and preparation conditions, which is beneficial to improve the filling rate and compaction density of the cathode material, thereby improving the volumetric specific capacity of the sodium ion battery.

The technical features of the above embodiments can be combined arbitrarily. To make the description concise, not all possible combinations of the technical features in the above embodiments are described. However, as long as there is no contradiction in the combination of these technical features, they should be considered to be within the scope of this specification.

The above are only optional examples of the present application and are not intended to limit the present application. For those skilled in the art, the present application may have various modifications and changes. Any modifications, equivalent substitutions, improvements, etc. made within the spirit and principles of the present application should be included in the scope of the claims of the present application.

## Claims

1. A metal oxide precursor, wherein the metal oxide precursor is a single-crystal structure, and a particle size distribution curve function f(x) of the metal oxide precursor represents a volume fraction corresponding to a particle size x, and satisfies the following conditions:
(1) when a ≤ x ≤ b, f(x) = ε + e^{-0.372+2.157(x+µ₁)-0.514(x+µ₁)²};
(2) when b ≤ x ≤ c, f(x) = ε + e^{-2.382+0.164(x+µ₂)-0.514(x+µ₂)²};
(3) when x < a or x > c, f(x) = 0;
in which, 0.214 µm ≤ a ≤ 0.260 µm, 1.78 µm ≤ b ≤ 3.1 µm, 8.2 µm ≤ c ≤ 31.2 µm, ε, µ₁, µ₂ are all error coefficients, and -1.5 ≤ ε ≤ 1.5, -0.35 ≤ µ₁ ≤ 0.35, -3 ≤ µ₂ ≤ 10.

2. The metal oxide precursor according to claim 1, wherein the particle size distribution curve function f(x) of the metal oxide precursor presents a unimodal normal particle size distribution curve.

3. The metal oxide precursor according to claim 1, wherein a maximum value f(x)ₘₐₓ of the particle size distribution curve function f(x) of the metal oxide precursor is 5 to 10.

4. The metal oxide precursor according to claim 1, wherein a full width at half maximum (FWHM) of the particle size distribution curve function f(x) of the metal oxide precursor is 3 µm to 5 µm.

5. The metal oxide precursor according to claim 1, wherein a cumulative particle size distribution curve function corresponding to the particle size distribution curve function f(x) of the metal oxide precursor is defined as Dₙ, n% = ∑ f(x), and when the cumulative particle size distribution curve function is D₂₅, 0.5 µm ≤ x ≤ 2.0 µm.

6. The metal oxide precursor according to claim 1, wherein a cumulative particle size distribution curve function corresponding to the particle size distribution curve function f(x) of the metal oxide precursor is defined as Dₙ, n% = Σ f(x), and when the cumulative particle size distribution curve function is D₅₀, 1.2 µm ≤ x ≤ 3.8 µm.

7. The metal oxide precursor according to claim 1, wherein a cumulative particle size distribution curve function corresponding to the particle size distribution curve function f(x) of the metal oxide precursor is defined as Dₙ, n% = Σ f(x), and when the cumulative particle size distribution curve function is D₇₅, 2 µm ≤ x ≤ 5 µm.

8. The metal oxide precursor according to claim 1, wherein in the particle size distribution curve function f(x) of the metal oxide precursor, a particle size distribution span value is 1.0 to 2.5.

9. The metal oxide precursor according to claim 1, wherein a general chemical formula of the metal oxide precursor is Mn_{y}M_{1-y}O₂, in which, 0.1 ≤ y ≤ 0.9, and M is at least one selected from Ni, Fe, Cu, Zn, Co, Ti, Mg, and Al.

10. The metal oxide precursor according to claim 1, wherein the metal oxide precursor exhibits a cubic crystal structure.

11. The metal oxide precursor according to any one of claims 1-10, wherein a tap density of the metal oxide precursor is 1.2 g/cm³ to 3.5 g/cm³.

12. A preparation method for the metal oxide precursor according to any one of claims 1-11, wherein the preparation method adopts spray pyrolysis.

13. The preparation method for the metal oxide precursor according to claim 12, wherein a pyrolysis temperature of the spray pyrolysis is 550°C to 950°C.

14. The preparation method for the metal oxide precursor according to claim 12, wherein an atomization pressure of the spray pyrolysis is 0.35 MPa to 0.7 MPa.

15. The preparation method for the metal oxide precursor according to claim 12, wherein a liquid feed flow rate obtained by the spray pyrolysis is 0.3 m³/hr to 0.8 m³/hr.

16. A cathode material, made from the metal oxide precursor according to any one of claims 1-11 or the metal oxide precursor prepared by the preparation method according to any one of claims 12-15.

17. A cathode plate, comprising: a cathode current collector, and a cathode material layer disposed on a surface of the cathode current collector, wherein the cathode material layer comprises the cathode material according to claim 16.

18. A secondary battery, comprising the cathode plate according to claim 17.
